# EUROPÄISCHE PATENTSCHRIFT

(11) **EP 0 416 414 B1**
(45) Veröffentlichungstag und Bekanntmachung des Hinweises auf die Patenterteilung: **27.09.1995**
(21) Anmeldenummer: 90116363.4
(22) Anmeldetag: 27.08.1990
(51) Int. Cl.: H01J 37/147, H01J 37/305

(54) **Verfahren und Vorrichtung zur Umlenkung eines Strahls**
Procedure and device for deviating a beam
Procédé et dispositif de déviation d'un faisceau

(30) Priorität: 05.09.1989 DE 3929475
(43) Veröffentlichungstag der Anmeldung: 13.03.1991
(73) Patentinhaber: BALZERS AKTIENGESELLSCHAFT, 9496 Balzers (LI)
(72) Erfinder: Wegmann, Urs Dipl. Ing. ETH, 9479 Oberschan (CH); Koller, Albert, 7320 Sargans (CH)
(74) Vertreter: Troesch, Jacques J., Dr. sc. nat.

(56) Entgegenhaltungen:
- EP-A- 0 018 247
- US-A- 3 609 378
- US-A- 3 924 210
- US-A- 4 064 352

## Beschreibung

Die vorliegende Erfindung betrifft ein Verfahren zur Umlenkung eines Strahls monopolar geladener Teilchen, insbesondere von Elektronen, bei dem in einer ersten Richtung, senkrecht zur örtlichen Ausbreitungsrichtung des Strahls, ein magnetisches Umlenk-Flussdichtefeld angelegt wird, um den Strahl in einer zweiten Richtung, senkrecht zur ersten und zur Strahlausbreitungsrichtung, umzulenken.

Ein solches Verfahren ist aus der US-A-4 064 352 bekannt. Dabei wird ein Elektronenstrahl einer Elektronenstrahlkanone zum Verdampfen eines Zielmaterials, ausgehend von einem Strahlerzeuger, um mehr als 180° umgelenkt, indem beidseits des Strahlverlaufs Polbakken einer magnetischen Polanordnung angeordnet sind, zwischen welchen das Umlenkfeld erzeugt wird. Der Elektronenstrahl läuft dabei abschnittsweise oberhalb der Stirnflächen der Polbacken durch, liegt somit im gekrümmten Feldbereich.

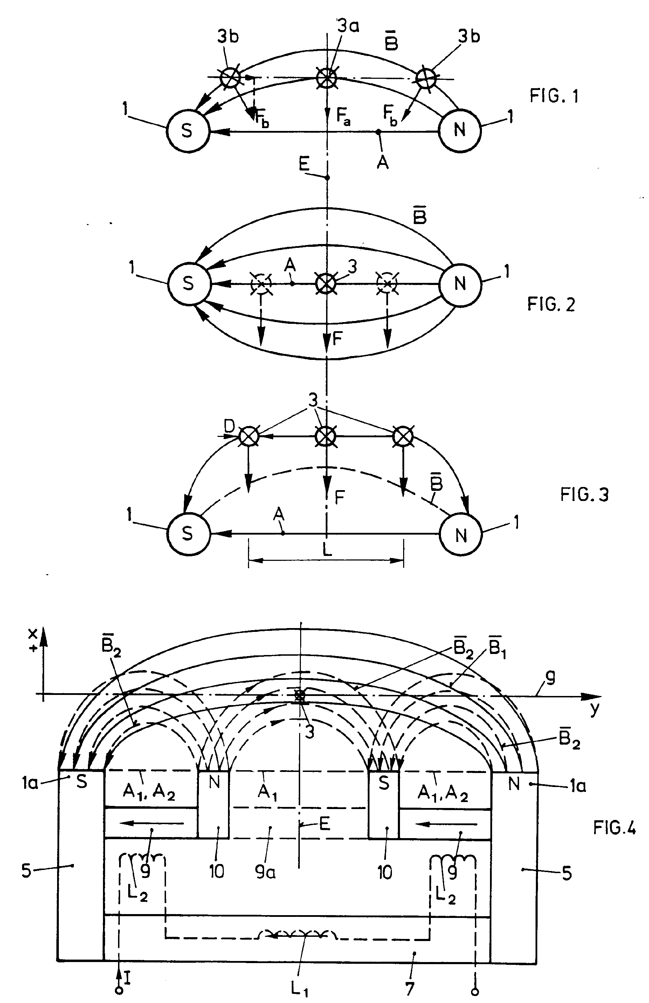

Ein solches Umlenkverfahren ist, wie anhand der Fig. 1 erläutert werden soll, nachteilig. In Fig. 1 sind schematisch zwei magnetische Pole 1 dargestellt, die einen magnetischen Dipol bilden. Es ergibt sich das qualitativ dargestellte Flussdichtefeld B̅, welches im Bereich der Dipolachse A geradlinig zwischen den Magnetpolen 1 verläuft. Wird nun gemäss der erwähnten US-A-4 064 352 ein Strahl geladener Teilchen, wie ein Elektronenstrahl 3, im wesentlichen in der Symmetrieebene E, senkrecht zur Dipolachse A zwischen den magnetischen Polen 1 durchgeführt, so erfahren die geladenen Teilchen eine Umlenkkraft F, wie in Fig. 1 eingetragen. Diese Umlenkkraft wird eingesetzt, um den Elektronenstrahl gemäss der erwähnten US-A-4 064 352 umzulenken. Ist nun die Lage des Strahls geladener Teilchen bezüglich der Symmetrieebene E, wie bei 3b dargestellt, versetzt, so ergeben sich Umlenkkräfte F_{b}, die im Unterschied zur Kraft Fa, bezogen auf die Dipolachse A, eine Querkomponente und eine Längskomponente aufweisen, wogegen beim in der Symmetrieebene E liegenden Strahl 3a nur eine Querkomponente zur Achse A entsteht.

Damit ist ersichtlich, dass eine Kopplung zwischen der Lage des Strahls in Richtung der Dipolachse A und der Umlenkung quer zu dieser Achse A besteht. Zudem werden die Strahlquerschnitte bei vorgegebenem Flussdichtefeld und bei Verschiebung der Lage des Strahls in Richtung der Dipolachse A, wie strichpunktiert eingetragen, mitbeeinflusst, es greifen an unterschiedlichen Bereichen der Strahlquerschnittsfläche unterschiedliche Kräfte an.

Ein weiterer Nachteil ist darin zu erblicken, dass bei der Lageänderung des Strahls parallel zur Achse A die Absolutbeträge der resultierenden Kräfte F ändern, weil der Strahl nicht entlang der Feldlinien verschoben wird, wo der Betrag der Feldvektoren konstant ist.

Aus der US-A-3 420 977 ist nun ein Verfahren bekannt, welches die genannten Nachteile nicht oder in reduziertem Umfange aufweist. Hier wird wiederum mittels magnetischer Polbacken ein Umlenkflussdichtefeld erzeugt und der Strahl geladener Teilchen, wiederum von Elektronen, zwischen den Polbacken durchgeführt. Die ausgedehnten magnetischen Polbacken erzeugen zwischen sich ein Feld mit nur wenig gekrümmten Feldlinien. Hier wird mithin der Elektronenstrahl 3, wie in Fig. 2 dargestellt, eher wie entlang der Dipolachse A verschoben, womit, idealisiert, immer gleichbleibende Querkräfte, bezogen auf die Achse A, resultieren.

Diese Anordnung ihrerseits hat aber den Nachteil, dass gerade bei Umlenkungen eines Strahls um einen grossen Winkel, wie um 180° und mehr, z.B. um 270°, die magnetische Anordnung deshalb voluminös wird, weil die Polbacken in langen Bereichen zwischen sich den Strahl aufnehmen müssen. Die vorgesehenen Polbakken sind weiter einer Beeinträchtigung durch die Auswirkung des Strahls auf einem Zielobjekt, insbesondere der Verdampfung von Material, vermehrt ausgesetzt. Zudem ist das Ausmass, mit dem der Strahl quer zu den Backen auf dem Zielobjekt, wie dem zu verdampfenden Tiegel, verschoben werden kann, abhängig vom Abstand und der Länge der Backen.

Grundsätzlich beruhen die Nachteile der bekannten Vorgehen darin, dass Bereiche des Umlenkflussdichtefeldes mit gekrümmten Feldlinien, also inhomogene Feldbereiche, sich für die Strahlführung nicht eignen, indem sie zu den anhand von Fig. 1 erläuterten Nachteilen führen.

Aus der US-A-3 924 210 ist es bekannt, an einer U-förmigen Magnetanordnung mit je einem in den Schenkeln liegenden Magnet das Feldlinienbild, welches zwischen den Schenkeln gegen die U-Basis eingestülpt ist, durch Vorsehen eines die U-Schenkel verbindenden Steges zu linearisieren, in seiner Längsrichtung in Abschnitten mit unterschiedlichem magnetischem Widerstand ausgebildet ist.

Die vorliegende Erfindung geht von der Aufgabe aus, auch inhomogene, gekrümmte Umlenkfeldbereiche ohne den genannten Nachteil (Fig. 1) für die Strahlführung verwenden zu können, womit sich die Flexibilität bezüglich Bauform von Organen zur Erzeugung des Umlenkfeldes, wie von Polbacken, ganz wesentlich erhöht.

Dies wird durch Vorgehen nach dem kennzeichnenden Teil von Anspruch 1 erreicht.

Bevorzugterweise wird dabei nach dem Wortlaut von Anspruch 2 vorgegangen.

Weiter wird, insbesondere beim Einsatz des erfindungsgemässen Verfahrens an einem Elektronenstrahl, wie und insbesondere am Strahl einer Elektronenkanone zum Verdampfen von Materialien in einer Beschichtungsanlage, der Strahl in erster Richtung, d.h. lateral im wesentlichen in der Richtung des Umlenkfeldes gemäss Wortlaut von Anspruch 3, gesteuert abgelenkt. Dabei bewirkt diese Ablenkung innerhalb des erfindungsgemäss linearisierten Umlenkfeldbereiches die Umlenkungsänderung kaum, anderseits kann die Umienkung verändert werden, ohne dass dabei die laterale Ablenkung verändert würde. Da weiter der Strahl in vorerst inhomogenen, erst durch das erfindungsgemässe Vorgehen homogenisierten Feldbereichen, insbesondere ausserhalb einer Polbackenanordnung, geführt werden kann, kann der Ablenkhub wesentlich erhöht werden, ohne dass dabei der Strahl in den unmittelbaren Bakkenbereich gelangte.

Bevorzugterweise wird auch die Ablenkung mittels eines steuerbaren Ablenkflussdichtefeldes vorgenommen, gemäss Wortlaut von Anspruch 4, welches im wesentlichen in zweiter Richtung zur Strahlausbreitungsrichtung steht, d.h. im wesentlichen in der Umlenkrichtung.

Im weiteren wird vorgeschlagen, gemäss Wortlaut von Anspruch 5, dass man, insbesondere beim Einsatz des erfindungsgemässen Verfahrens an der erwähnten Elektronenkanone, den Strahl bezüglich seiner Querschnittsfläche gesteuert verändert, im wesentlichen entkoppelt von der Umlenkung und gegebenenfalls der vorgenommenen erwähnten lateralen Ablenkung. Im letzten Fall sind drei voneinander weitgehendst entkoppelte Steuergrössen für den Strahl gegeben, so dass einerseits die Lage seiner Auftrefffläche auf einem Ziel in zwei Koordinaten veränderbar ist und zusätzlich die Grösse dieser Auftrefffläche und mithin die aufgebrachte Energiedichte.

Gemäss Wortlaut von Anspruch 6 wird dabei der Strahl bevorzugterweise bezüglich seiner Querschnittsfläche mittels eines Fokussierflussdichtefeldes gesteuert, das man im wesentlichen ebenfalls in zweiter Richtung, jedoch gegenpolig beidseits des Strahls, anlegt und/oder ebenso in erster Richtung, wobei durch die Gegenpoligkeit beidseits des Strahls innerhalb der betroffenen Strahlquerschnittsfläche "Zug-" bzw. "Druckkräfte" die Strahlquerschnittsfläche komprimieren bzw. ausdehnen.

Wie im weiteren aus der US-A-4 064 352 ersichtlich, sind dort zur Erzeugung des Umlenkflussdichtefeldes ein Paar beidseits des Strahls ausgedehnter Magnetpolanordnungen in Form von Polbacken vorgesehen. Diese erstrecken sich über den gesamten, zwischen Strahlerzeuger und Ziel vom Elektronenstrahl durchlaufenen Bereich. Damit durchläuft der Strahl im wesentlichen gleichbleibende Umlenkfeldverhältnisse.

Im obgenannten Sinne ist es ja mitunter Ziel der vorliegenden Erfindung, Polanordnungen zur Umlenkung des Strahls vorzusehen, die möglichst klein sind und auch ausserhalb ihres Bereiches die Strahlbahn zu beeinflussen erlauben. Dies wird bei Vorgehen gemäss Anspruch 7 erreicht.

Durch eine solche gezielte Formung der Berandungsflächen der Polanordnungen können nun dem Strahl entlang seiner Ausbreitung erwünscht gerichtete Umlenkkräfte aufgebracht werden, und es kann mithin eine Bahn ausgelegt werden mit vorgegebener, in Ausbreitungsrichtung sich ändernder Krümmung auch ausserhalb der Polbacken.

Damit ist nun die Möglichkeit gegeben, gemäss Wortlaut von Anspruch 8, die Umlenkung in Zielrichtung mit abnehmender Krümmung auszubilden, indem man die Berandungsflächen in Strahlzielrichtung neigt, womit nun die vorgesehenen Polanordnungen, weiterhin in Zielrichtung betrachtet, wesentlich kürzer ausgebildet werden können und der Strahl nach Verlassen des Bereiches zwischen der Polanordnung in immer weniger gekrümmter Bahn auf die ausserhalb der Polanordnungen angeordnete Zielfläche gerichtet werden kann, derart, dass die Polanordnung von den Auswirkungen des Strahls auf der Zielfläche geschützt ist, weiter relativ grosse Zielflächen eingesetzt werden können, da die Auftrefffläche des Strahls auf dem Ziel mehr verschoben werden kann, als dies der Polbackenabstand zuliesse.

Ausgehend von der eingangs genannten Vorrichtung wird die genannte Aufgabe nach dem Wortlaut von Anspruch 9 gelöst.

In einfacher Art und Weise werden dabei die Zusatzpole gemäss Wortlaut von Anspruch 10 ausgelegt.

In den Ansprüchen 11 bis 24 sind weitere bevorzugte vorteilhafte Ausbildungsvarianten der erfindungsgemässen Vorrichtung spezifiziert.

Es wird insbesondere gemäss Anspruch 23 eine Vorrichtung vorgeschlagen, bei der die Polbacken möglichst klein sind und nicht bis hin in den Bereich des vorgesehenen Zielobjektes vorzusehen sind.

Die Erfindung wird anschliessend beispielsweise anhand von Figuren erläutert, mit weiteren Vorteilen.

Es zeigen:
- Figuren 1 und 2: Erläuterungen der Umlenk-verfahren gemäß dem Stand der Technik,
- Fig. 3: schematisch eine erfindungsgemässe Ausbildung des Umlenkfeldes für den Strahl,
- Fig. 4: schematisch ein bevorzugtes Vorgehen zur Erzeugung des erfindungsgemäss linearisierten Umlenkfeldes mittels einer bevorzugten Ausführungsvariante einer erfindungsgemässen Anordnung,
- Fig. 5a bis 5c: die entlang einer geradlinigen Verschiebungsbahn für den Strahl gemäss Fig. 4 auftretenden Feldbeträge (5a), Vertikalkomponenten der Feldvektoren (5b), Horizontalkomponenten der Feldvektoren (5c), je der Umlenk- und Kompensationsfelder und des resultierenden Feldes,
- Fig. 6: schematisch eine bevorzugte Ausführungsvariante der erfindungsgemässen Vorrichtung,
- Fig. 7: schematisch, und in Darstellung analog zu Fig. 6, eine weiter ausgebaute bevorzugte Ausführungsvariante der erfindungsgemässen Vorrichtung mit Möglichkeit zur Lateralablenkung des Strahls,
- Fig. 8: ausgehend von der Darstellung gemäss Fig. 7 eine Weiterbildung der erfindungsgemässen Vorrichtung mit Fokussierungssteuerung,
- Fig. 9a bis 9c: schematische Seitenansichten einer erfindungsgemässen Vorrichtung mit gezielt geformten Polflächen für das Umlenkfeld.

In Fig. 3 ist schematisch das erfindungsgemässe Vorgehen im Gegensatz zu dem in Fig. 1 und 2 dargestellten gezeigt. Zwischen den beiden Magnetpolen 1 entsteht primär der hier gestrichelt eingetragene, bekannte Feldverlauf des magnetischen Flussdichtefeldes B̅. Erfindungsgemäss wird nun dieses Feld in einem Bereich L, welcher wesentlich länger ist als der Durchmesser D des Strahls 3, in Polachsrichtung betrachtet, d.h. parallel zur Dipolachse A, linearisiert, indem die Feldkomponenten senkrecht zur Dipolachse A im wesentlichen kompensiert werden.

Daraus ist nun ersichtlich, dass die Lage des Teilchenstrahls 3 verschoben werden kann, ohne dass an der resultierenden Kraft F Kraftkomponenten in Richtung der Dipolachse A entstünden. Im weiteren bleibt, unabhängig von der Lageverschiebung in der genannten Richtung, auch die aufgebrachte Umlenkkraft F konstant. Da alle Ladungen in den jeweilig betroffenen Querschnittsflächen des Strahles 3 bei Lageverschiebung in Richtung der Dipolachse A gleichbleibenden Kräften unterworfen bleiben, ergibt sich auch keine Querschnittsformänderung des Strahls bei seiner Verschiebung, obwohl er oberhalb bzw. ausserhalb des Bereiches der Pole 1 verläuft.

In Fig. 4 ist schematisch eine bevorzugte Realisation des Feldverlaufes gemäss Fig. 3 dargestellt bzw. schematisch eine erfindungsgemässe Vorrichtung hierfür.

Zwischen den zwei Magnetpolen 1a, beispielsweise gebildet durch Polbacken 5, beidseits eines Magneten 7, entsteht das gekrümmte Flussdichtefeld B̅₁. Die Lage des Teilchenstrahls 3 sei auf der von den Polen 1a äquidistanten und somit zur magnetischen Achse des Magneten 7 parallelen Geraden g festgelegt. Entlang dieser Geraden g soll der Strahl 3 auch lageveränderbar sein gemäss den Ausführungen zu Fig. 3.

Im Bereich der Magnetpole 1a und mithin in gleicher Richtung von der Geraden g versetzt, wie die Pole 1a, werden Kompensationsmagnete 9 vorgesehen mit Polen 10 einerseits, wobei die anderseitigen Pole direkt durch die ersterwähnten 1a gebildet sein können. Durch die Magnete 9 werden Kompensationsflussdichtefelder B̅₂ gebildet, wie gestrichelt dargestellt. Dabei versteht sich von selbst, dass die Darstellung von Fig. 4 keinerlei Anspruch auf Exaktheit erhebt, sondern lediglich den qualitativen Feldverlauf darstellt. Anstelle der Magnete 9 könnte auch ein Magnet 9a vorgesehen werden.

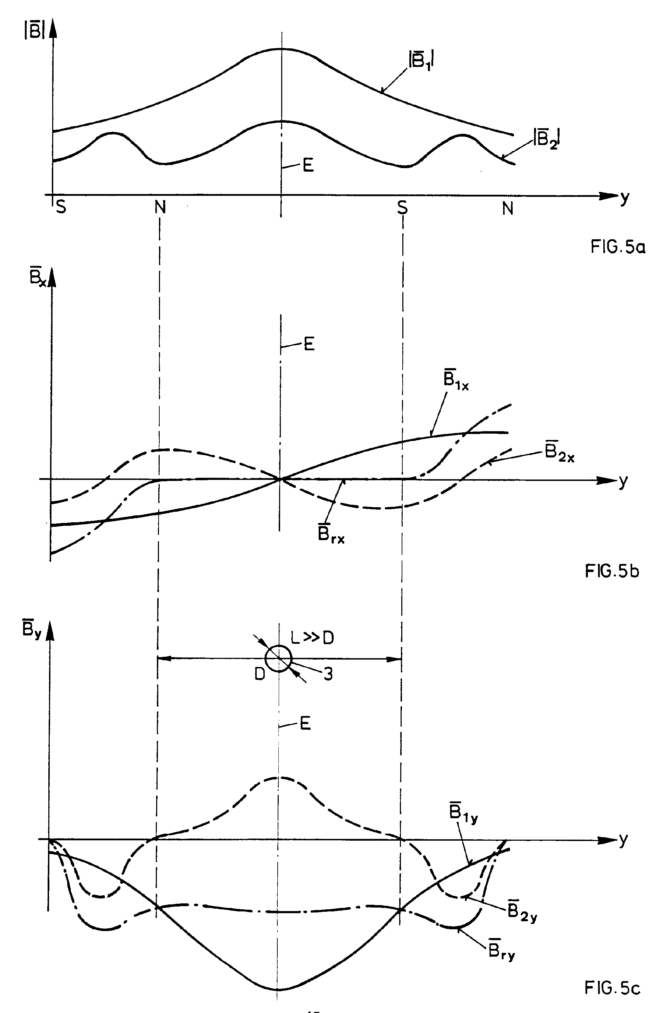

In Fig. 5a ist nun der Betrag einerseits des zwischen den Polen 1a entstehenden Feldes B̅₁ dargestellt sowie die jeweiligen Beträge der Kompensationsfelder B̅₂, wenn auf der Geraden g in der in Fig. 4 angegebenen Richtung y fortgeschritten wird. Dabei ist berücksichtigt, dass Feldlinien Orte gleicher Feldstärkebeträge festlegen und dass diese mit kleiner werdendem Abstand von den jeweiligen Dipolachsen A₁ zwischen den Polen 1a bzw. A₂ zwischen den Polen der Magnete 9, die in der Ausführung gemäss Fig. 4, teilweise zusammenfallend, zunehmen.

In Fig. 5b sind die Vertikalkomponenten in x-Richtung gemäss Fig. 4 des Flussdichtefeldes bei wie beschriebenem Fortschreiten auf der Geraden g dargestellt. Zur Beurteilung des resultierenden Feldes dürfen bekanntlich die Vektorkomponenten der beiden Feldanteile direkt addiert werden. Somit ergeben sich, wie in Fig. 5b gestrichelt dargestellt, im Bereich L, der je nach Auslegung grösser oder kleiner sein kann, in jedem Fall aber wesentlich grösser ist als der Durchmesser D des Teilchenstrahls 3, verschwindende x-Komponenten B̅ᵣₓ des resultierenden Feldes B̅ᵣ (in Fig. 4 nicht eingetragen!).

Eine entsprechende Darstellung für die Horizontalkomponenten in y-Richtung ist in Fig. 5c gezeigt. Daraus ist ersichtlich, dass die Horizontalkomponenten B̅_{ry} des resultierenden Flussdichtefeldes B̅ᵣ über den Abschnitt L im wesentlichen konstant sind.

Selbstverständlich sind auch die Darstellungen in den Fig. 5 nur qualitativ und sollen dazu dienen, den Linearisierungseffekt der gemäss Fig. 4 vorgesehenen Kompensationsfelder B̅₂ zu erläutern.

Wie aus den Betrachtungen zu den Fig. 4 und 5 hervorgeht, wird die Homogenisierung des ursprünglichen Umlenkflussdichtefeldes B̅₁ dadurch erreicht, dass in den Randzonen die Krümmungen verstärkt werden, dafür ein Mittenbereich mit geringerer Krümmung erzielt wird. Aus dem zu Beginn inhomogenen, gekrümmten Feld wird, auf einer harmonischen Synthese (Umkehrung der harmonischen Analyse, Fourier-Entwicklung) entsprechende Art, räumlich ein genähert rechteckförmiges Feldbild erzeugt.

Dieses Vorgehen lässt sich überall dort anwenden, wo, räumlich, ein homogenes Magnetfeld erwünscht ist.

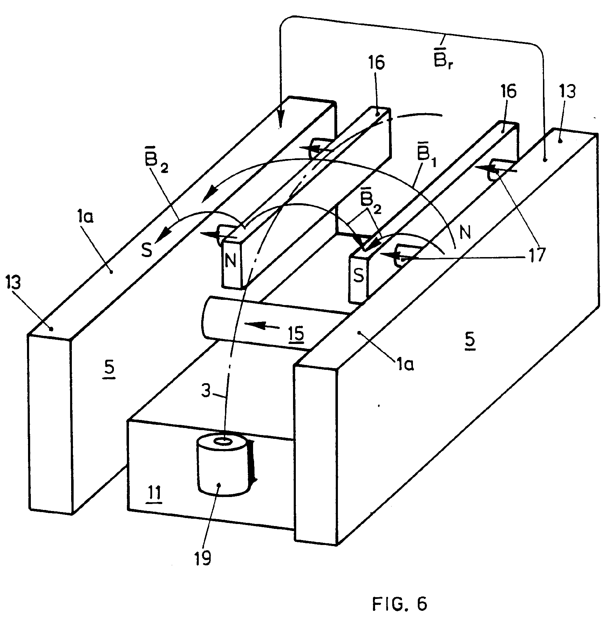

In Fig. 6 ist schematisch eine bevorzugte Ausführungsform der erfindungsgemässen Vorrichtung dargestellt. Zwischen Polbacken 5, die U-förmig durch einen Sockelteil 11 vereint sind, werden, mit den Bakkenstirnflächen 13, magnetische Pole 1a gebildet. Dies durch Vorsehen eines Magneten 15 zwischen den Polbacken 5. Beim Magneten 15 kann es sich um einen Elektromagneten, einen Permanentmagneten oder um eine kombinierte Anordnung von Elektro- und Permanentmagneten handeln. Im Bereich der Stirnflächen 13, entsprechend den magnetischen Polen 1a, werden Polbacken 16 vorgesehen, welche über Magnete 17 mit den Polbakken 5 verbunden sind. Auch bei den Magneten 17 kann es sich um Permanentmagnete, um Elektromagnete oder um eine Kombination von Elektro- und Permanentmagneten handeln.

Die durch die dargestellten Magnetanordnungen qualitativ resultierenden Felder B̅₁ und B̅₂ sind beispielsweise eingetragen, ebenso, strichpunktiert, der von einem Strahlerzeuger 19 erzeugte Teilchen-, insbesondere Elektronenstrahl 3. Mit B̅ᵣ ist wiederum das aus den Feldern B̅₁ und B̅₂ resultierende rechteckförmige Feld dargestellt.

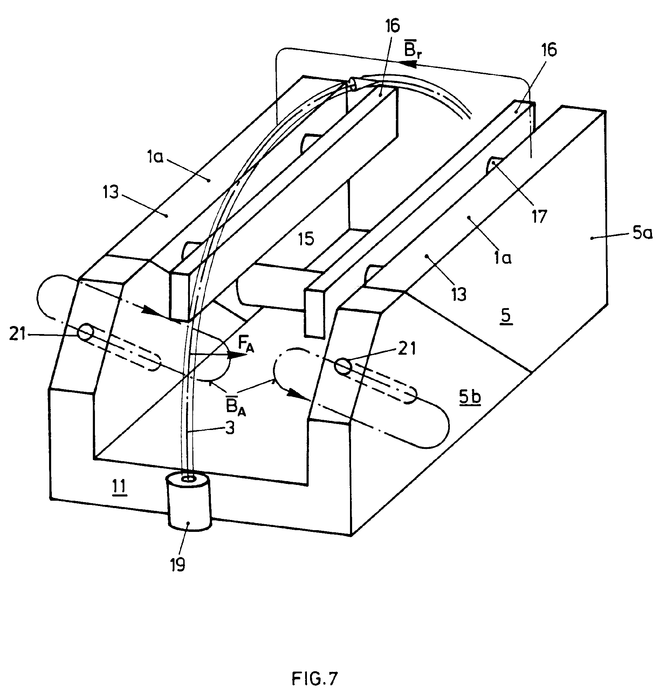

In Fig. 7 ist eine bevorzugte Weiterausbildung der Anordnung gemäss Fig. 6 dargestellt, wie sie insbesondere zur Steuerung des Elektronenstrahls bei einer Elektronenstrahlkanone für das Verdampfen von Materialien in einer Beschichtungsanlage eingesetzt wird. Sich entsprechende Teile weisen die bereits in Fig. 6 verwendeten Positionszeichen auf.

Um den Strahl 3, insbesondere den Elektronenstrahl, gemäss den Ausführungen im Zusammenhang mit den Fig. 3, 4 und 5 lateral, d.h. gemäss Fig. 4 in y-Richtung, verschieben zu können, wird ein Ablenkflussdichtefeld B̅_{A} angelegt, welches beidseits des Strahls 3 gleich gepolt ist und welches einerseits senkrecht zur Ausbreitungsrichtung des Strahls 3 im betroffenen Bereich ist, anderseits auch senkrecht zu der Richtung des Umlenkfeldes B̅ᵣ. Durch dieses Flussdichtefeld B̅_{A} wird je nach Feldrichtung der Strahl gemäss der resultierenden Kraft F_{A} hin- oder hergeschoben.

Zur Erzeugung des Ablenkfeldes B̅_{A} sind an den Backen 5 Magnetanordnungen 21 vorgesehen, wobei es sich wiederum um Permanentmagnete, Elektromagnete oder deren Kombination handeln kann. Während die die Pole 1a bildenden Partien 5a der Backen 5 aus Eisen gefertigt sind, also aus ferromagnetischem Material, sind die Magnete 21 in den Abschnitten 5b der Backen 5, in ma gnetisch weitgehend isolierendem Material, wie aus Inox (Warenzeichen), gehaltert.

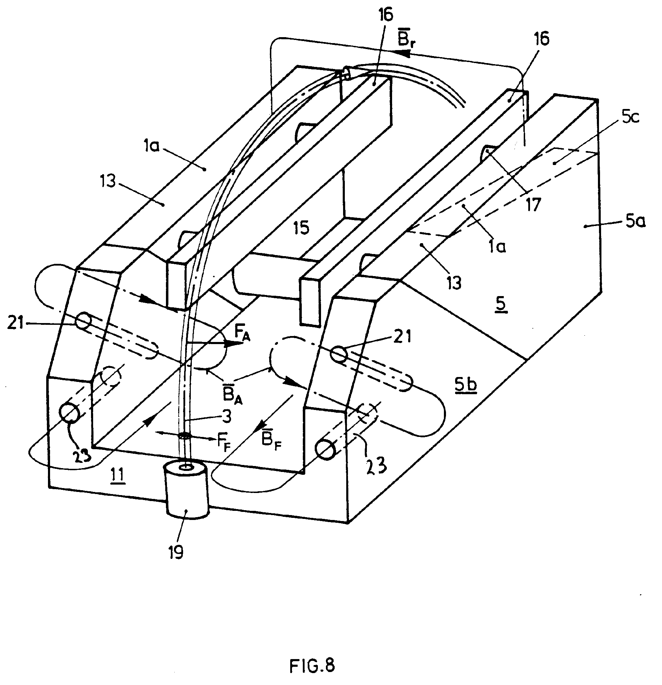

In Fig. 8 ist, ausgehend von der Darstellung gemäss Fig. 7, eine weitere bevorzugterweise vorgesehene Massnahme dargestellt. In den Backenbereichen 5b ist ein weiteres Paar von Magneten 23 vorgesehen, welche nun, im Unterschied zu den Ablenkmagneten 21, ein Flussdichtefeld B̅_{F} erzeugen, welches beidseits des Strahls 3 umgekehrt gepolt ist. Mit Hilfe dieses Feldes B̅_{F} wird die Strahlquerschnittsfläche Q beeinflusst, indem, wie mit F_{F} dargestellt, immer gegengerichtete Kräfte resultieren, die die Strahlquerschnittsfläche senkrecht zum Feld dehnen oder stauchen. Dies im Unterschied, wie erwähnt, zum Ablenkfeld der Magnete 23, welches immer eine resultierende Kraft in einer Richtung auf die Teilchen im Strahl bewirkt. Auch bei den Magneten 23 handelt es sich um Permanentmagnete, Elektromagnete oder, und bevorzugterweise, um eine Kombination dieser Magnetarten.

Der Aufbau der ganzen Anordnung ist unter Berücksichtigung der Kühlungserfordernisse bevorzugterweise aus Kupfer, Inox (Warenzeichen) und reinem Eisen aufgebaut. Insbesondere auch dadurch, dass die vorgesehenen Magnete bzw. mindestens Teile davon in magnetisch schlecht leitendem Material, wie Inox (Warenzeichen), gehaltert sind, werden magnetische Shunts verhindert, die die zur Wirkung auf den Strahl auszunützenden Feldanteile verminderten.

Dadurch, dass diese Magnete bzw. Teile davon auch in elektrisch schlecht leitendem Material, ebenfalls eine Eigenschaft von Inox (Warenzeichen), gehaltert sind, wird das Entstehen von Gegeninduktivitäten aufgrund von Wirbelströmen weitgehend verhindert. Dadurch werden die Zeitkonstanten bei schaltendem Verändern der Flussdichtefelder erstaunlich klein, trotz des äusserst kompakten Aufbaus, womit Veränderungen der Felder mit Grenzfrequenzen bis zu einigen kHz möglich sind. Damit konnte bei ca. 10 kW Leistung der Elektronenstrahl auf einer Verdampfungsfläche ohne weiteres mit 1 kHz lage- und fokus-gewobbelt werden.

In Fig. 4 ist im weiteren gestrichelt angezeigt, wie, bei Steuerung der Strahlumlenkung die Kompensationsfelder B̅₂ in Funktion des Umlenkfeldes B̅₁ gesteuert werden können, falls notwendig: Die Wicklungen L₂ für elektromagnetische Erzeugung oder Miterzeugung der Felder B̅₂ werden z.B. mit einer Wicklung L₁ zur Erzeugung oder Miterzeugung des Feldes B̅₁ seriegeschaltet, oder auf andere, dem Fachmann nun nahegelegte Art und Weise werden die Erregungsströme in gegenseitiger Abhängigkeit geführt.

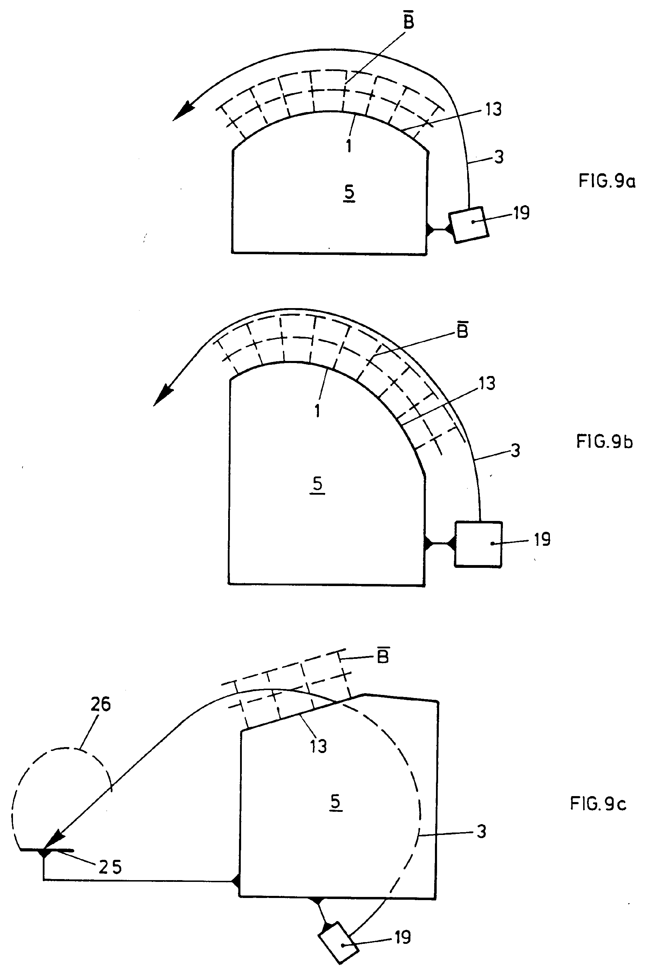

Anhand der Fig. 9 soll ein weiterer Aspekt der vorliegenden Erfindung beschrieben werden. Sie zeigen schematisch Seitenansichten einer erfindungsgemässen Vorrichtung.

Gemäss Fig. 9a und 9b sind die Polbacken 5 an ihren, die Pole bildenden Stirnflächen 1 gezielt gebogen, um dem vom Strahlerzeuger 19, der bezüglich der Magnetanordnung mit den Backen 5 fix montiert wird, erzeugten Strahl 3 eine erwünschte vorgegebene Bahn zu verleihen. Mit B̅ ist dabei der Verlauf des Umlenkfeldes dargestellt, gestrichelt der Verlauf von Aequipotentiallinien bzw. -flächen.

Bei Einsatz der erfindungsgemässen Vorrichtung als Steuereinrichtung an einer Elektronenkanone, mit deren Elektronenstrahl ein Zielobjekt, beispielsweise in einer Beschichtungsanlage, verdampft wird, wird die in Fig. 9c schematisch dargestellte Anordnung bevorzugt. Zu Beginn, d.h. nach Verlassen des Strahlerzeugers 19, wird der Strahl 3 vorerst zwischen den Backen 5 im dort weitgehend homogenen Umlenkflussdichtefeld geführt.

Darnach verlässt der Strahl 3 den Backenbereich und verläuft oberhalb der Stirnseiten 13, wo nun auch bevorzugterweise die Linearisierungsmassnahmen, wie sie anhand von Fig. 4 und 5 erläutert wurden, vorgenommen werden. Da die Flächen 13 gegen ein schematisch eingetragenes Zielobjekt 25, welches bezüglich der Bakken 5 fix positioniert ist, geneigt sind, wird die Strahlbahn zusätzlich gekrümmt, so dass sie nach Verlassen des Umlenkfeldeinflussbereiches geneigt und gestreckt auf die entfernte Zielfläche 25 trifft. Damit wird ermöglicht, dass das Zielobjekt 25 abseits der Backen 5 angeordnet werden kann, was einerseits eine Reduktion der Backenausdehnung erlaubt und anderseits sicherstellt, dass der Strahl in weiten Bereichen ausserhalb der Backen 5 verläuft und letztere kaum mehr beschichtet werden, da sie abseits vom Einfluss der Verdampfung 26 liegen.

Die in Fig. 8 gestrichelt dargestellte Ausformung der Backe 5 bei 5c entspricht der in Fig. 9c schematisch dargestellten Abschrägung der die Pole bildenden Stirnflächen 13.

Mit dem erfindungsgemäss vorgeschlagenen Vorgehen zur Feldhomogenisierung werden Feldbereiche ausserhalb der Magnetpolbereiche für die Strahlführung ausnützbar. Damit kann aber der Feldverlauf auf einfache Art und Weise durch die Form der Polbackenstirnflächen mitbeeinflusst werden. Die Bauflexibilität der Vorrichtung wird drastisch erhöht. Da die Zielfläche nur ausserhalb der Backen liegen kann, werden grosse Lateralhübe für die Strahlverstellung möglich. In Fig. 9c beispielsweise: Bereits eine kleine Lateralauslenkung des Strahls zwischen den Backen ergibt eine wesentlich grössere Auslenkung des Strahls am Zielobjekt.

Mit der Anordnung, wie sie schematisch in Fig. 8 dargestellt ist, wird eine höchst kompakte Steuereinheit, insbesondere für einen Elektronenstrahl einer Elektronenkanone, realisiert, bei der im wesentlichen unabhängig voneinander die Strahlfokussierung, die laterale Strahlablenkung und die Strahlumlenkung gesteuert werden können.

## Patentansprüche

1. Verfahren zur Umlenkung eines Strahls monopolar geladener Teilchen, insbesondere von Elektronen, bei dem in einer ersten Richtung, senkrecht zur örtlichen Ausbreitungsrichtung des Strahls, ein magnetisches Umlenk-Flussdichtefeld angelegt wird, um den Strahl in einer zweiten Richtung, senkrecht zur ersten und zur Strahlausbreitungsrichtung, umzulenken, bei dem man das Umlenk-Flussdichtefeld mit gekrümmten Feldlinien, entsprechend dem Feld eines magnetischen Dipols abseits der Dipolachse, erzeugt und den Strahl in wesentlichen Bahnbereichen im Bereich mit gekrümmten Feldlinien durchleitet, dadurch gekennzeichnet, dass man auf Art einer harmonischen Synthese in dem Bereich mit den gekrümmten Feldlinien, durch den der Strahl durchgeleitet wird, mittels mindestens eines Zusatz-Flussdichtefeldes, ein resultierendes Umlenk-Flussdichtefeld mit im wesentlichen linearisiertem Feldlinienbild erzeugt.

2. Verfahren nach Anspruch 1, dadurch gekennzeichnet, dass man dem Umlenk-Flussdichtefeld mit gekrümmten Feldlinien, in erster Richtung betrachtet, ein Zusatz-Flussdichtefeld wie folgt überlagert:
- die Krümmung der Feldlinien des Zusatz-Flussdichtefeldes ist seitlich des Bereichs gleichsinnig wie die Krümmung der Feldlinien des Umlenkfeldes und vorzugsweise grösser als diese,
- die Polarität der Feldvektoren ist dort so, dass sie die Krümmungen der Feldlinien gleichsinnig durchlaufen.

3. Verfahren nach einem der Ansprüche 1 oder 2, dadurch gekennzeichnet, dass man weiter den Strahl in erster Richtung gesteuert ablenkt.

4. Verfahren nach Anspruch 3, dadurch gekennzeichnet, dass man den Strahl mittels eines steuerbaren Ablenk-Flussdichtefeldes ablenkt, das im wesentlichen in der zweiten Richtung verläuft.

5. Verfahren nach einem der Ansprüche 1 bis 4, dadurch gekennzeichnet, dass man den Strahl bezüglich seiner Querschnittsfläche gesteuert verändert, im wesentlichen entkoppelt von der Umlenkung und gegebenenfalls der Ablenkung.

6. Verfahren nach Anspruch 5, dadurch gekennzeichnet, dass man den Strahl bezüglich seiner Querschnittsfläche mittels eines Fokussier-Flussdichtefeldes gesteuert verändert, das man gegenpolig beidseits des Strahls anlegt.

7. Verfahren nach einem der Ansprüche 1 bis 6, dadurch gekennzeichnet, dass der Strahl in einer Umlenkebene, die zwischen einem Paar Polbacken liegt, mindestens in einem Abschnitt ausserhalb der Polbacken durchgeleitet wird und dass man durch Formung der Polflächen der Polbacken in Ebenen parallel zur Umlenkungsebene das resultierende Umlenk-Flussdichtefeld entlang der Umlenkbahn des Strahls vorgibt.

8. Verfahren nach Anspruch 7, dadurch gekennzeichnet, dass man die Polflächen in Strahlzielrichtung mindestens abschnittsweise neigt, um die Umlenkkrümmung des Strahls in Zielrichtung zu verkleinern.

9. Vorrichtung zur Durchführung des Verfahrens nach einem der Ansprüche 1 bis 8 mit einer magnetischen Umlenkpolanordnung (1, 1a), die von Pol zu Pol, welche auf einer Achse (A) angeordnet sind, ein gekrümmtes Umlenk-Flussdichtefeld (B̅₁) erzeugt und bei der ein Bereich (L) für den Strahlengang zwischen den Polen (1, 1a) im Bereich des gekrümmten Feldes vorgesehen ist und bei der das Umlenk-Flussdichtefeld (B̅₁) im Bereich für den Strahlengang in einer Richtung im wesentlichen senkrecht dazu verläuft, dadurch gekennzeichnet, dass Zusatz-Felderzeugungsorgane (9, 10, 16, 17) vorgesehen sind mit Polen, die eine zur Achse der Umlenkpolanordnung (1, 1a) parallele Achse festlegen, um die Krümmung des Umlenk-Flussdichtefeldes (B̅₁) im Bereich für den Strahlengang (L) zu kompensieren (B̅ᵣ), indem sie ein Zusatz-Flussdichtefeld (B̅₂) erzeugen, das auf Art einer harmonischen Synthese mit dem gekrümmten Umlenk-Flussdichtefeld ein resultierendes Umlenk-Flussdichtefeld mit im wesentlichen linearem Feldlinienbild erzeugt.

10. Vorrichtung nach Anspruch 9, dadurch gekennzeichnet, dass bezüglich des Bereiches (L) für den Strahlengang (3) im wesentlichen symmetrisch hierzu und auf die gleiche Seite bezüglich des Bereiches für den Strahlengang versetzt wie die Umlenkpolanordnung, mindestens ein Paar magnetischer Zusatzpole (1a, 10, 16) angeordnet ist, deren Polabstand kürzer ist als derjenige der Umlenkpole, vorzugsweise kürzer ist als deren halber Abstand, vorzugsweise wesentlich kürzer, und dass die Zusatzpole ein Feld erzeugen, dessen Vektorkomponenten in der zum Strahlengang senkrechten Richtung gleichgerichtet sind wie diejenigen des Umlenk-Flussdichtefeldes und dessen Feldlinien gleichsinnig wie diejenigen des Umlenk-Flussdichtefeldes gekrümmt sind.

11. Vorrichtung nach Anspruch 10, dadurch gekennzeichnet, dass die Pole Pole von Permanent- und/oder Elektromagnetanordnungen sind.

12. Vorrichtung nach Anspruch 10 oder 11, dadurch gekennzeichnet, dass die Pole Elektromagnetpole umfassen und die Elektromagnete in Abhängigkeit voneinander angesteuert sind, vorzugsweise seriegeschaltete Spulen (L₁, L₂) umfassen.

13. Vorrichtung nach einem der Ansprüche 9 bis 12, dadurch gekennzeichnet, dass die Pole (1, 1a) für das Umlenk-Flussdichtefeld auch durch die Stirnflächen eines Paars U-schenkelförmig angeordneter Polbacken (5) gebildet sind und der Bereich für den Strahlengang im wesentlichen hierzu symmetrisch und, entlang einem wesentlichen Umlenkungsabschnitt, ausserhalb einer Verbindungsfläche der Schenkelstirnflächen liegt.

14. Vorrichtung nach einem der Ansprüche 9 bis 13, dadurch gekennzeichnet, dass eine Ablenksteueranordnung (21) vorgesehen ist, um die Lage (y) des Strahls (3) auch in der Richtung des resultierenden Umlenk-Flussdichtefeldes (B̅ᵣ) gesteuert zu verändern.

15. Vorrichtung nach Anspruch 14, dadurch gekennzeichnet, dass die Ablenksteueranordnung mindestens eine, vorzugsweise je eine magnetische Dipolanordnung (21) beidseits des Bereiches für den Strahlengang (3) umfasst, deren Achse bzw. Achsen im wesentlichen senkrecht zur Richtung des resultierenden Umlenk-Flussdichtefeldes angeordnet ist bzw. sind.

16. Vorrichtung nach den Ansprüchen 13 und 15, dadurch gekennzeichnet, dass die Ablenkdipole (21) im wesentlichen parallel zu den Backenebenen (5) angeordnet sind und vorzugsweise baulich mit den Backen vereint sind.

17. Vorrichtung nach einem der Ansprüche 15 oder 16, dadurch gekennzeichnet, dass die Ablenkdipole Elektro- und/oder Permanentmagnete umfassen.

18. Vorrichtung nach einem der Ansprüche 9 bis 17, dadurch gekennzeichnet, dass eine Fokussiersteueranordnung für den Strahl (3) vorgesehen ist.

19. Vorrichtung nach Anspruch 18, dadurch gekennzeichnet, dass die Fokussiersteueranordnung beidseits des Bereiches für den Strahlengang (3) je eine magnetische Fokussierdipolanordnung (23) umfasst, deren Achsen im wesentlichen senkrecht zur Richtung des Umlenk-Flussdichtefeldes stehen und/oder die eine Wehnelt-Elektrodeneinheit aufweist.

20. Vorrichtung nach den Ansprüchen 13 und 19, dadurch gekennzeichnet, dass die Fokussierdipole (23) im wesentlichen parallel zu den Backenebenen angeordnet sind, vorzugsweise baulich damit vereint sind.

21. Vorrichtung nach einem der Ansprüche 9 bis 20, dadurch gekennzeichnet, dass mindestens ein Teil der Polanordnungen in magnetisch schlecht leitendem Material, wie in Inox (Warenzeichen), gehalten ist, vorzugsweise in Material, das magnetisch und elektrisch schlecht leitet.

22. Vorrichtung nach einem der Ansprüche 19 bis 21, dadurch gekennzeichnet, dass die Fokussierdipole Permanent- und/oder Elektromagnete umfassen.

23. Vorrichtung nach einem der Ansprüche 9 bis 22 mit einer Vorrichtung zur Montage eines Zielobjektes für den Strahl, welches im wesentlichen eine Zielebene definiert, dadurch gekennzeichnet, dass eine magnetische Polanordnung (1, 1a) in Form seitlich des Bereiches für den Strahlengang (3) verlaufender Polbacken (5) vorgesehen ist, zwischen deren Polflächen (13) das resultierende Umlenk-Flussdichtefeld (B̅ᵣ) erzeugt wird, wobei die Polbacken-Polflächen (13) mindestens abschnittsweise gegen die Montageanordnung hin geneigt sind.

24. Vorrichtung nach Anspruch 23, dadurch gekennzeichnet, dass die Montageanordnung so ausgelegt ist, dass ein montiertes Zielobjekt ausserhalb des Polbackenbereiches liegt.

25. Verwendung des Verfahrens nach mindestens einem der Ansprüche 1 bis 8 oder der Vorrichtung nach mindestens einem der Ansprüche 9 bis 24 für die Elektronenstrahlsteuerung an einer Elektronenstrahl-Verdampfungsanlage.

26. Verwendung des Verfahrens nach mindestens einem der Ansprüche 1 bis 8 oder der Vorrichtung nach mindestens einem der Ansprüche 9 bis 24 als Stellverfahren bzw. Stellglied für die Verdampfungsrate an einer Elektronenstrahl-Verdampfungsanlage, wie im Rahmen einer Verdampfungsratenregelung.

27. Beschichtungsanlage mit einer Vorrichtung nach einem der Ansprüche 9 bis 24.

28. Verfahren zur Steuerung der Lage und/oder der Ausdehnung der Auftrefffläche eines Strahls monopolar geladener Teilchen an einer Vorrichtung gemäss einem der Ansprüche 9 bis 24, dadurch gekennzeichnet, dass die gesteuerte Grösse mit einer Stellgrenzfrequenz bis in den kHz-Bereich verstellt wird.

## Claims

1. A method of deflecting a beam of monopolar-charged particles, in particular electrons, wherein a magnetic deflection flux density field is applied in a first direction, perpendicularly to the local direction of propagation of the beam, in order to deflect the beam in a second direction, perpendicularly to the first and to the beam propagation directions, wherein the deflection flux density field is produced with curved field lines, corresponding to the field of a magnetic dipole remote from the dipole axis, and a substantial part of the beam path is passed through the region with curved field lines, characterised in that a resulting deflection flux density field with a substantially linearised field density pattern is produced in the region with the curved field lines through which the beam is passed in the manner of a harmonic synthesis, namely by means of at least one additional flux density field.

2. A method according to claim 1, characterised in that an additional flux density field is superimposed on the deflection flux density field with curved field lines, as considered in a first direction, in the following manner:
- the curvature of the field lines of the additional flux density field laterally of the region has the same direction as the curvature of the field lines of the deflection field and is preferably greater than same, and
- the polarity of the field vectors is there such that they pass along the curvatures of the field lines in the same direction.

3. A method according to one of the claims 1 or 2, characterised in that the beam is further diverted in the first direction in controlled manner.

4. A method according to claim 3, characterised in that the beam is diverted by means of a controllable diversion flux density field which extends substantially in the second direction.

5. A method according to one of the claims 1 to 4, characterised in that the beam is controlledly altered in respect of its cross-sectional area, substantially decoupled from deflection and possibly from diversion.

6. A method according to claim 5, characterised in that the beam is controlledly altered in respect of its cross-sectional area by means of a focussing flux density field which is applied in opposite-polarisation relationship on both sides of the beam.

7. A method according to one of the claims 1 to 6, characterised in that the beam is passed along a deflection plane which is between a pair of pole pieces, at least in a portion outside the pole pieces, and that the resulting deflection flux density field is predetermined along the deflection path of the beam by virtue of shaping of the pole surfaces of the pole pieces in planes in parallel relationship with the deflection plane.

8. A method according to claim 7, characterised in that the pole surfaces are inclined at least at portions thereof in the beam target direction in order to reduce the deflection curvature of the beam in the target direction.

9. Apparatus for carrying out the method according to one of the claims 1 to 8 with a magnetic deflection pole arrangement (1, 1a) which produces a curved deflection flux density field (B̅₁) from pole to pole which are arranged on an axis (A), and in which there is provided a region (L) for the beam path between the poles (1, 1a) in the region of the curved field, and in which the deflection flux density field (B̅₁), in the region for the beam path, extends substantially perpendicularly thereto, characterised in that there are provided additional field producing members (9, 10, 16, 17) which establish an axis which is parallel with respect to the axis of the deflection pole arrangement (1, 1a) in order to compensate (B̅ᵣ) for the curvature of the deflection flux density field (B̅₁) in the region for the beam path (L) by their producing of an additional flux density field (B̅₂) which, in the manner of a harmonic synthesis with the curved deflection flux density field, produces a resulting deflection flux density field with a substantially linear field line pattern.

10. Apparatus according to claim 9, characterised in that at least one pair of magnetic additional poles (1a, 10, 16) is arranged with respect to the region (L) for the beam path (3) substantially symmetrically in relation thereto and displaced on the same side with respect to the region for the beam path as the deflection pole arrangement, the pole spacing of the additional poles being shorter than that of the deflection poles, preferably shorter than half the spacing thereof, preferably substantially shorter, and that the additional poles produce a field whose vector components have the same direction in the direction perpendicular to the beam path as those of the deflection flux density field and whose field lines are curved in the same direction as those of the deflection flux density field.

11. Apparatus according to claim 10, characterised in that the poles are poles of permanent and/or electro-magnet arrangements.

12. Apparatus according to claim 10 or claim 11, characterised in that the poles include electro-magnet poles and the electro-magnets are controlled in dependence on each other and preferably include series-connected coils (L₁, L₂).

13. Apparatus according to one of the claims 9 to 12, characterised in that the poles (1, 1a) for the deflection flux density field are also formed by the end faces of a pair of pole pieces (5) which are arranged in the form of the limbs of a U-shape and wherein the region for the beam path is disposed substantially symmetrically with respect thereto and lies, along a substantial deflection portion, outside a connecting plane of the end faces of the limbs.

14. Apparatus according to one of the claims 9 to 13, characterised in that there is provided a diversion control arrangement (21) for controlledly altering the position (y) of the beam (3) also in the direction of the resulting deflection flux density field (B̅ᵣ).

15. Apparatus according to claim 14, characterised in that the deflection control arrangement includes at least one and preferably includes a respective magnetic dipole arrangement (21) on both sides of the region for the beam path (3), the axis or axes of which is or are arranged substantially perpendicularly to the direction of the resulting deflection flux density field.

16. Apparatus according to the claims 13 and 15, characterised in that the diversion dipoles (21) are arranged substantially parallel to the pole piece planes (5) and are preferably structurally combined with the pole pieces.

17. Apparatus according to one of the claims 15 or 16, characterised in that the diversion dipoles include permanent and/or electro-magnets.

18. Apparatus according to one of the claims 9 to 17, characterised in that there is provided a focussing control arrangement for the beam (3).

19. Apparatus according to claim 18, characterised in that the focussing control arrangement includes on each side of the region for the beam path (3) a respective magnetic focussing dipole arrangement (23) whose axes are substantially perpendicular to the direction of the deflection flux density field and/or which has a Wehnelt electrode unit.

20. Apparatus according to the claims 13 and 19, characterised in that the focussing dipoles (23) are arranged substantially parallel to the pole piece planes and are preferably structurally combined therewith.

21. Apparatus according to one of the claims 9 to 20, characterised in that at least a part of the pole arrangements is held in material which is of poor magnetic conductor material, such as of Inox (trade mark), preferably in material which is of poor magnetic and electrical conductance.

22. Apparatus according to one of the claims 19 to 21, characterised in that the focussing dipoles include permanent and/or electro-magnets.

23. Apparatus according to one of the claims 9 to 22 having a device for mounting a target object for the beam which substantially defines a target plane, characterised in that there is provided a magnetic pole arrangement (1, 1a) in the form of pole pieces (5) which extend laterally of the region for the beam path (3) and between whose pole faces (13) the resulting deflection flux density field (B̅ᵣ) is produced, wherein the pole piece pole faces (13) are inclined at least to a part towards the mounting arrangement.

24. Apparatus according to claim 23, characterised in that the mounting arrangement is so designed that a mounted target object lies outside the pole piece region.

25. Use of the method according to at least one of the claims 1 to 8 or of the apparatus according to at least one of the claims 9 to 24 for electron beam control on an electron beam evaporation installation.

26. Use of the method according to at least one of the claims 1 to 8 or of the apparatus according to at least one of the claims 9 to 24 as a control method and as a control member respectively for the evaporation rate at an electron beam evaporation installation as in the context of an evaporation rate negative feedback control.

27. A coating installation having an apparatus according to one of the claims 9 to 24.

28. A method of controlling the position and/or the extent of the impingement area of a beam of monopolar-charged particles at an apparatus according to one of the claims 9 to 24, characterised in that the controlled parameter is adjusted with a control limit frequency up to the kHz-range.

## Revendications

1. Procédé de déviation d'un faisceau de particules à charge monopolaire, en particulier d'électrons, selon lequel on applique un champ magnétique à densité de flux de déviation dans une première direction, perpendiculairement par rapport au sens local de propagation du faisceau, afin de dévier le faisceau dans une seconde direction perpendiculaire à la première et au sens de propagation du faisceau, et selon lequel on génère le champ à densité de flux de déviation avec des lignes de champ courbes, suivant le champ d'un dipôle magnétique, à l'écart de l'axe de dipôle, et on fait passer le faisceau dans des zones de trajectoire sensibles dans la zone comportant les lignes de champ courbes, caractérisé en ce qu'on génère, à la manière d'une synthèse harmonique dans la zone comportant les lignes de champ courbes traversées par le faisceau et à l'aide d'au moins un champ à densité de flux supplémentaire, un champ à densité de flux de déviation résultant présentant un schéma de lignes de champ sensiblement linéarisé.

2. Procédé selon la revendication 1, caractérisé en ce qu'on superpose au champ à densité de flux de déviation comportant des lignes de champ courbes, si on considère une première direction, un champ à densité de flux supplémentaire de la manière suivante :
- la courbure des lignes du champ à densité de flux supplémentaire est dans le même sens, sur le côté de la zone, que la courbure des lignes du champ de déviation, et de préférence supérieure à celle-ci,
- la polarité des vecteurs de champ est telle, à cet endroit, que ces vecteurs traversent les courbures des lignes de champ dans le même sens.

3. Procédé selon l'une des revendications 1 ou 2, caractérisé en ce qu'on soumet par ailleurs le faisceau à une déflexion de façon commandée dans la première direction.

4. Procédé selon la revendication 3, caractérisé en ce qu'on soumet le faisceau à une déflexion à l'aide d'un champ à densité de flux de déflexion apte à être commandé, qui s'étend sensiblement dans la seconde direction.

5. Procédé selon l'une des revendications 1 à 4, caractérisé en ce qu'on modifie de façon commandée le faisceau par rapport à sa surface de section transversale, sensiblement découplé de la déviation et éventuellement de la déflexion.

6. Procédé selon la revendication 5, caractérisé en ce qu'on modifie de façon commandée le faisceau par rapport à sa surface de section transversale, à l'aide d'un champ à densité de flux de focalisation qu'on applique avec des pôles opposés des deux côtés du faisceau.

7. Procédé selon l'une des revendications 1 à 6, caractérisé en ce que dans un plan de déviation situé entre une paire de joues polaires, le faisceau passe à l'extérieur desdites joues polaires au moins dans une section, et en ce qu'on prédéfinit le champ à densité de flux de déviation résultant, le long de la trajectoire de déviation du faisceau, grâce à une conformation des surfaces polaires desdites joues dans des plans parallèles au plan de déviation.

8. Procédé selon la revendication 7, caractérisé en ce qu'on incline les surfaces polaires, au moins par sections, dans le sens de la cible du faisceau afin de réduire la courbure de déviation du faisceau dans le sens de la cible.

9. Dispositif pour la mise en oeuvre du procédé selon l'une des revendications 1 à 8, comportant un dispositif magnétique à pôles de déviation (1, 1a) qui génère entre les pôles, disposés sur un axe (A), un champ à densité de flux de déviation courbe (B̅₁), avec lequel il est prévu une zone (L) pour le passage du faisceau entre les pôles (1, 1a), dans la zone du champ courbe, et avec lequel le champ à densité de flux de déviation (B̅₁), dans la zone prévue pour le passage du faisceau, s'étend dans un sens sensiblement perpendiculaire à celui-ci, caractérisé en ce qu'il est prévu des organes de production de champ supplémentaire (9, 10, 16, 17) comportant des pôles qui déterminent un axe parallèle à l'axe du dispositif à pôles de déviation (1, 1a) afin de compenser (B̅ᵣ) la courbure du champ à densité de flux de déviation (B̅₁) dans la zone prévue pour le passage du faisceau (L), dans la mesure où ces organes génèrent un champ à densité de flux supplémentaire (B̅₂) qui génère lui-même, à la manière d'une synthèse harmonique avec le champ à densité de flux de déviation courbe, un champ à densité de flux de déviation résultant présentant un schéma de ligne de champ sensiblement linéaire.

10. Dispositif selon la revendication 9, caractérisé en ce qu'il est prévu, sensiblement symétriquement par rapport à la zone (L) prévue pour le passage du faisceau (3) et décalée du même côté que le dispositif à pôles de déviation par rapport à ladite zone prévue pour le passage du faisceau, au moins une paire de pôles magnétiques supplémentaires (1a, 10, 16) dont l'écartement polaire est inférieur à celui des pôles de déviation et de préférence inférieur à la moitié de celui-ci, de préférence sensiblement inférieur, et en ce que les pôles supplémentaires génèrent un champ dont les composantes vectorielles sont dirigées dans le même sens, perpendiculairement au passage du faisceau, que celles du champ à densité de flux de déviation, et dont les lignes de champ sont courbées dans le même sens que celles du champ à densité de flux de déviation.

11. Dispositif selon la revendication 10, caractérisé en ce que les pôles sont les pôles de dispositifs à aimants permanents et/ou à électro-aimants.

12. Dispositif selon la revendication 10 ou 11, caractérisé en ce que les pôles comprennent des pôles d'électro-aimants et les électro-aimants sont excités indépendamment les uns des autres et comprennent de préférence des bobines (L₁, L₂) montées en série.

13. Dispositif selon l'une des revendications 9 à 12, caractérisé en ce que les pôles (1, 1a) prévus pour le champ à densité de flux de déviation sont aussi formés par les surfaces frontales d'une paire de joues polaires (5) disposées pour former les branches d'un U, la zone prévue pour le passage du faisceau est sensiblement symétrique à celles-ci et est située le long d'une section de déviation sensible, à l'extérieur d'une surface de liaison des surfaces frontales des branches.

14. Dispositif selon l'une des revendications 9 à 13, caractérisé en ce qu'il est prévu un dispositif de commande de déflexion (21) afin de modifier de façon commandée la position (y) du faisceau (3) même dans le sens du champ à densité de flux de déviation résultant (B̅ᵣ).

15. Dispositif selon la revendication 14, caractérisé en ce que le dispositif de commande de déflexion comprend au moins un dispositif de dipôle magnétique (21), de préférence un de chaque côté de la zone prévue pour le passage du faisceau (3), dont l'axe ou les axes sont disposés sensiblement perpendiculairement au sens du champ à densité de flux de déviation résultant.

16. Dispositif selon les revendications 13 et 15, caractérisé en ce que les dipôles déflecteurs (21) sont disposés sensiblement parallèlement aux plans des joues (5) et sont de préférence réunis de par la construction à celles-ci.

17. Dispositif selon l'une des revendications 15 ou 16, caractérisé en ce que les dipôles déflecteurs comprennent des électro-aimants et/ou des aimants permanents.

18. Dispositif selon l'une des revendications 9 à 17, caractérisé en ce qu'il est prévu un dispositif de commande de focalisation pour le faisceau (3).

19. Dispositif selon la revendication 18, caractérisé en ce que le dispositif de commande de focalisation comprend, de chaque côté de la zone prévue pour le passage du faisceau (3), un dispositif magnétique à dipôles de focalisation (23) dont les axes sont sensiblement perpendiculaires au sens du champ à densité de flux de déviation et/ou qui comporte une unité formant électrode de modulation.

20. Dispositif selon les revendications 13 et 19, caractérisé en ce que les dipôles de focalisation (23) sont disposés sensiblement parallèlement aux plans des joues et sont de préférence réunis à celles-ci de par la construction.

21. Dispositif selon l'une des revendications 9 à 20, caractérisé en ce qu'une partie au moins des dispositifs polaires est maintenue dans un matériau mauvais conducteur magnétique comme l'inox (marque déposée), de préférence dans un matériau mauvais conducteur magnétique et électrique.

22. Dispositif selon l'une des revendications 19 à 21, caractérisé en ce que les dipôles de focalisation comprennent des aimants permanents et/ou des électro-aimants.

23. Dispositif selon l'une des revendications 9 à 22 comportant un dispositif pour le montage d'un objet cible pour le faisceau, lequel objet définit sensiblement un plan cible, caractérisé en ce qu'il est prévu un dispositif magnétique à pôles (1, 1a) sous la forme de joues polaires (5) qui s'étendent sur le côté de la zone prévue pour le passage du faisceau (3) et entre les surfaces polaires (13) desquelles est généré le champ à densité de flux de déviation résultant (B̅ᵣ), les surfaces polaires (13) desdites joues étant inclinées au moins par sections vers le dispositif de montage.

24. Dispositif selon la revendication 23, caractérisé en ce que le dispositif de montage est conçu pour qu'un objet cible monté se trouve à l'extérieur de la zone des joues polaires.

25. Utilisation du procédé selon l'une au moins des revendications 1 à 8 ou du dispositif selon l'une au moins des revendications 9 à 24 pour la commande d'un faisceau d'électrons sur une installation de vaporisation par faisceau d'électrons.

26. Utilisation du procédé selon l'une au moins des revendications 1 à 8 ou du dispositif selon l'une au moins des revendications 9 à 24 comme procédé ou organe de réglage pour la vitesse de vaporisation sur une installation de vaporisation par faisceau d'électrons, comme dans le cadre d'une régulation de vitesse de vaporisation.

27. Installation de revêtement pourvue d'un dispositif selon l'une des revendications 9 à 24.

28. Procédé pour commander la position et/ou l'extension de la surface de bombardement d'un faisceau de particules à charge monopolaire au niveau d'un dispositif selon l'une des revendications 9 à 24, caractérisé en ce que la grandeur commandée est réglée avec une fréquence limite de réglage allant jusque dans la zone des kHz.
